# EUROPEAN PATENT APPLICATION

(11) **EP 4 435 847 A1**
(43) Date of publication of application: **25.09.2024**
(21) Application number: 24151763.0
(22) Date of filing: 15.01.2024
(51) Int. Cl.: H01L 21/8234, H01L 27/088, H01L 29/06, H01L 29/10, H01L 29/165, H01L 29/66, H01L 29/775, H01L 29/78, H01L 29/786

(54) **INTEGRATED CIRCUIT DEVICE**

(30) Priority: 21.03.2023 KR 20230036926
(71) Applicant: Samsung Electronics Co., Ltd., Suwon-si, Gyeonggi-do 16677 (KR)
(72) Inventor: HWANG, Ingeon, 16677 Suwon-si, Gyeonggi-do (KR); KIM, Jinbum, 16677 Suwon-si, Gyeonggi-do (KR); KIM, Hyojin, 16677 Suwon-si, Gyeonggi-do (KR); LEE, Sangmoon, 16677 Suwon-si, Gyeonggi-do (KR); NAM, Yongjun, 16677 Suwon-si, Gyeonggi-do (KR); LEE, Taehyung, 16677 Suwon-si, Gyeonggi-do (KR)
(74) Representative: Kuhnen & Wacker Patent- und Rechtsanwaltsbüro PartG mbB

(57) **Abstract**

An integrated circuit device (100) includes a fin-type active region (F1) on a substrate (102), a nanosheet (N1, N2; N3) on a fin top surface of the fin-type active region, the nanosheet being apart from the fin top surface of the fin-type active region in a vertical direction, a gate line (160) surrounding the nanosheet on the fin-type active region, and a source/drain region (130) on the fin-type active region, the source/drain region being in contact with the nanosheet, wherein the nanosheet includes a multilayered sheet comprising a first outer semiconductor sheet (S1), a core semiconductor sheet (S2), and a second outer semiconductor sheet (S3), which are sequentially stacked in the vertical direction.

## Description

### BACKGROUND

The inventive concept relates to an integrated circuit (IC) device, and more particularly, to an IC device including a field-effect transistor (FET).

As the size of IC devices is reduced, there is a need to increase the integration density of FETs on a substrate. Accordingly, a horizontal nanosheet FET (hNSFET) including a plurality of horizontal nanosheets stacked on the same layout area has been developed. As the integration density of IC devices increases and the size of the IC devices decreases, hNSFETs require not only a high operating speed but also high operating accuracy. Accordingly, a vast amount of research has been conducted on optimizing structures of the hNSFETs.

### SUMMARY

The inventive concept provides an IC device, which has a channel structure capable of precisely controlling a required threshold voltage to improve reliability.

According to an aspect of the inventive concept, there is provided an IC device including a fin-type active region on a substrate, a nanosheet on a fin top surface of the fin-type active region, the nanosheet being apart from the fin top surface of the fin-type active region in a vertical direction, a gate line surrounding the nanosheet on the fin-type active region, and a source/drain region on the fin-type active region, the source/drain region being in contact with the nanosheet, wherein the nanosheet includes a multilayered sheet including a first outer semiconductor sheet, a core semiconductor sheet, and a second outer semiconductor sheet, which are sequentially stacked in the vertical direction.

According to another aspect of the inventive concept, there is provided an IC device including a fin-type active region extending long in a first lateral direction on a substrate, a nanosheet stack apart from a fin top surface of the fin-type active region in a vertical direction, the nanosheet stack facing the fin top surface of the fin-type active region, and the nanosheet stack including a plurality of nanosheets, which are at different vertical distances from the fin top surface of the fin-type active region, a gate line extending long in a second lateral direction on the fin-type active region, the gate line surrounding the plurality of nanosheets on the fin-type active region, wherein the second lateral direction intersects with the first lateral direction, and a pair of source/drain regions respectively on both sides of the gate line on the fin-type active region, each source/drain region being in contact with the plurality of nanosheets, wherein each of the plurality of nanosheets includes a multilayered sheet including a first outer semiconductor sheet, a core semiconductor sheet, and a second outer semiconductor sheet, which are sequentially stacked in the vertical direction.

According to another aspect of the inventive concept, there is provided an IC device including a first transistor in a first region of a substrate and a second transistor in a second region of the substrate, wherein the first transistor includes a first fin-type active region on the substrate, a first nanosheet stack on the first fin-type active region, the first nanosheet stack including a first-type nanosheet, the first-type nanosheet including a multilayered sheet including a first outer semiconductor sheet, a core semiconductor sheet, and a second outer semiconductor sheet, which are sequentially stacked in a vertical direction, a first gate line surrounding the first-type nanosheet on the first fin-type active region, and a pair of first source/drain regions on the first fin-type active region, the pair of first source/drain regions being in contact with the first-type nanosheet, wherein the second transistor includes a second fin-type active region on the substrate, a second nanosheet stack on the second fin-type active region, the second nanosheet stack including a second-type nanosheet having a different structure from the first-type nanosheet, a second gate line surrounding the second-type nanosheet on the second fin-type active region, and a pair of second source/drain regions on the second fin-type active region, the pair of second source/drain regions being in contact with the second-type nanosheet.

### BRIEF DESCRIPTION OF THE DRAWINGS

Implementations of the inventive concept will be more clearly understood from the following detailed description taken in conjunction with the accompanying drawings in which:
FIG. 1 is a plan layout diagram of some components of an IC device according to some implementations;
FIG. 2A is a cross-sectional view of some components in a cross-section taken along line X1 - X1' of FIG. 1;
FIG. 2B is a cross-sectional view of some components in a cross-section taken along line Y1 - Y1' of FIG. 1;
FIG. 2C is an enlarged cross-sectional view of some components in local region "EX1" of FIG. 2A;
FIG. 3 is a cross-sectional view of an IC device according to some implementations;
FIG. 4 is a cross-sectional view of an IC device according to some implementations;
FIG. 5 is a cross-sectional view of an IC device according to some implementations;
FIG. 6 is a block diagram of an IC device according to some implementations;
FIG. 7 is a cross-sectional view of an IC device according to some implementations;
FIG. 8 is a cross-sectional view of an IC device according to some implementations;
FIG. 9A is an enlarged cross-sectional view of some components in local region "EX51" of FIG. 8;
FIG. 9B is an enlarged cross-sectional view of some components in local region "EX52" of FIG. 8;
FIG. 10 is a block diagram of an IC device according to some implementations; and

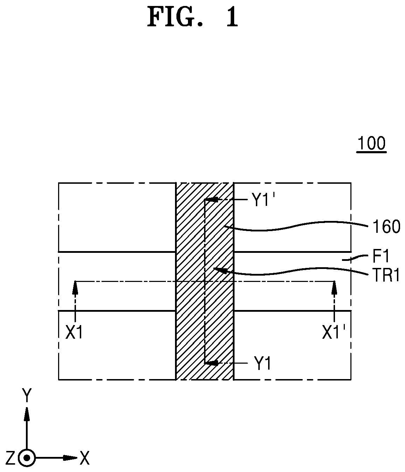

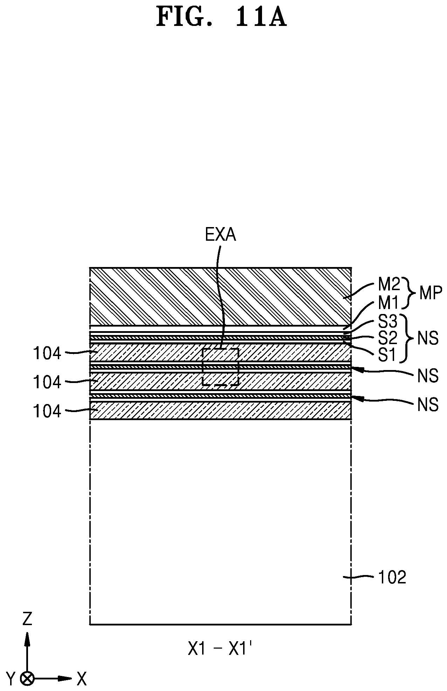

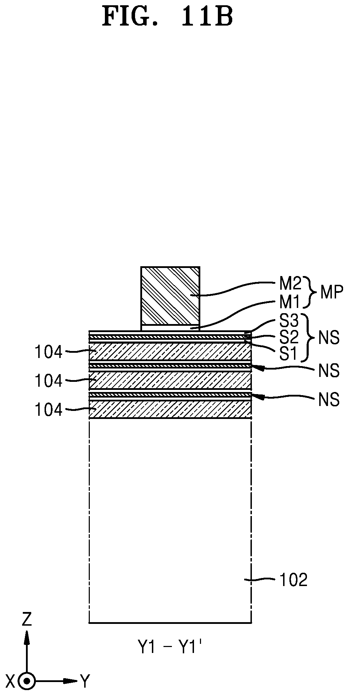

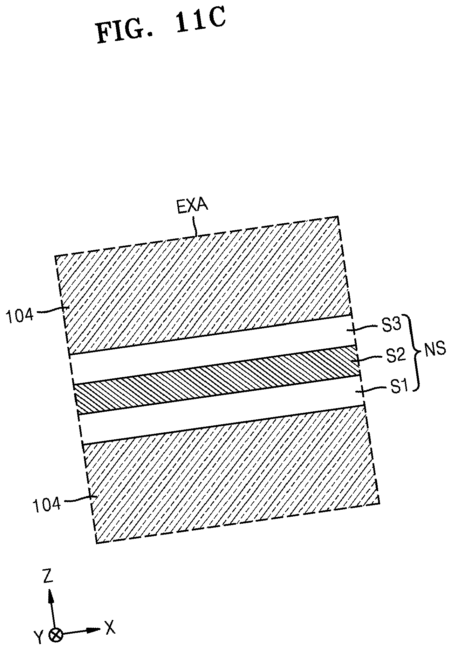

FIGS. 11A to 17B are cross-sectional views of an IC device being manufactured according to a process sequence of a method, according to some implementations, wherein FIGS. 11A, 12A, 13A, 14A, 15A, 16A, and 17A are cross-sectional views of some components in a portion corresponding to the cross-section taken along line X1 - X1' of FIG. 1, according to the process sequence, FIGS. 11B, 12B, 13B, 14B, 15B, 16B, and 17B are cross-sectional views of some components in a portion corresponding to the cross-section taken along the line Y1 - Y1' of FIG. 1, according to the process sequence, and FIG. 11C is an enlarged cross-sectional view of some components in local region "EXA" of FIG. 11A.

### DETAILED DESCRIPTION

Hereinafter, implementations will be described in detail with reference to the accompanying drawings. The same reference numerals are used to denote the same elements in the drawings, and repeated descriptions thereof are omitted.

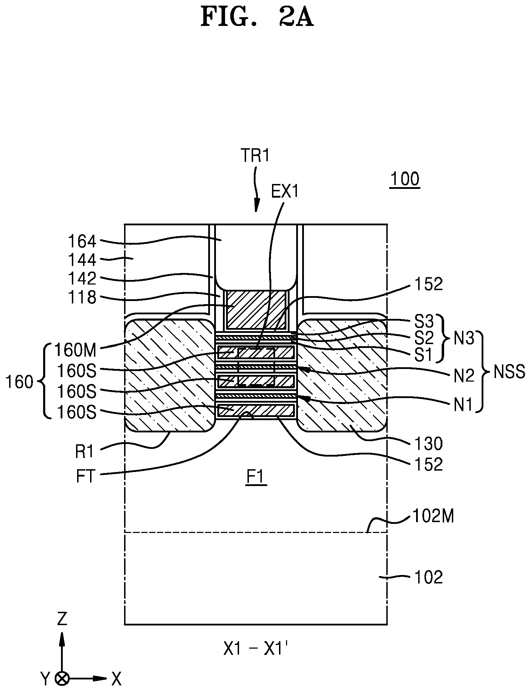

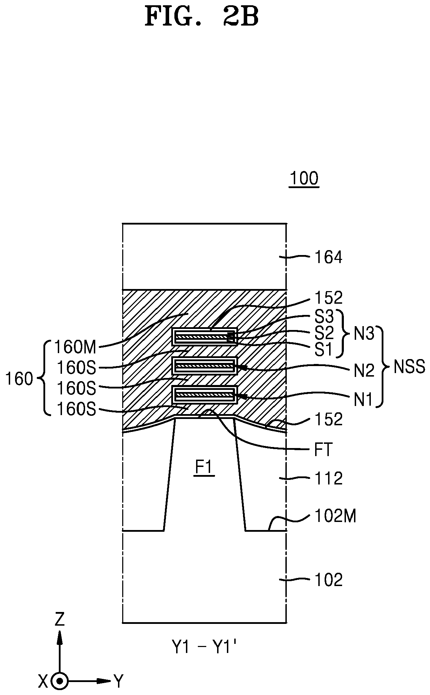

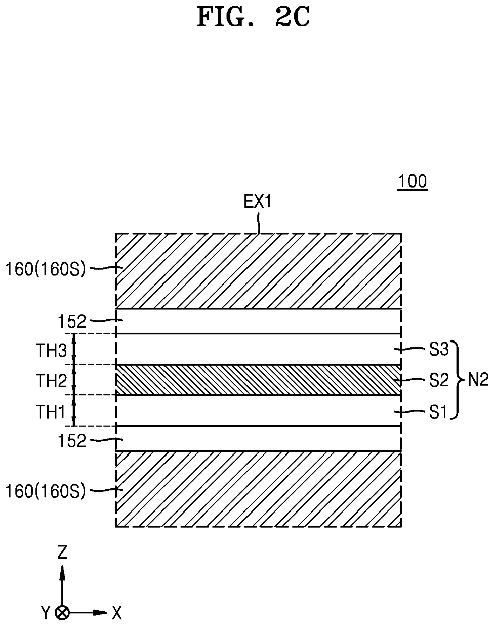

FIG. 1 is a plan layout diagram of some components of an IC device 100 according to some implementations. FIG. 2A is a cross-sectional view of some components in a cross-section taken along line X1 - X1' of FIG. 1. FIG. 2B is a cross-sectional view of some components in a cross-section taken along line Y1 - Y1' of FIG. 1. FIG. 2C is an enlarged cross-sectional view of some components in local region "EX1" of FIG. 2A. The IC device 100 including a FET having a gate-all-around structure including an active region of a nanowire or nanosheet type and a gate surrounding the active region is described with reference to FIGS. 1 and 2A to 2C.

Referring to FIGS. 1 and 2A to 2C, the IC device 100 may include a substrate 102 and a fin-type active region F1, which protrudes from the substrate 102 in a vertical direction (Z direction). The fin-type active region F1 may extend long in a first lateral direction (X direction).

The substrate 102 may include a semiconductor element, such as silicon (Si) or germanium (Ge), or a compound semiconductor, such as silicon germanium (SiGe), silicon carbide (SiC), gallium arsenide (GaAs), indium arsenide (InAs), indium gallium arsenide (InGaAs), or indium phosphide (InP). As used herein, each of the terms "SiGe," "SiC," "GaAs," "InAs," "InGaAs," and "InP" refers to a material including elements included therein, without referring to a chemical formula representing a stoichiometric relationship. The substrate 102 may include a conductive region, for example, a doped well or a doped structure.

A device isolation film 112 facing both sidewalls of the fin-type active region F1 may be on the substrate 102. The device isolation film 112 may include an oxide film, a nitride film, or a combination thereof.

A nanosheet stack NSS and a gate line 160 may be on the fin-type active region F1. The gate line 160 may extend long in a second lateral direction (Y direction), which intersects with the first lateral direction (X direction).

The nanosheet stack NSS may be apart from the fin-type active region F1 in the vertical direction (Z direction) and face a fin top surface FT of the fin-type active region F1. As used herein, the term "nanosheet" refers to a conductive structure having a cross-section that is substantially perpendicular to a direction in which current flows. The nanosheet may be interpreted as including a nanowire. The nanosheet stack NSS may include a first nanosheet N1, a second nanosheet N2, and a third nanosheet N3, which overlap each other in the vertical direction (Z direction) on the fin top surface FT of the fin-type active region F1.

The gate line 160 may surround the first to third nanosheets N1, N2, and N3 included in the nanosheet stack NSS. A transistor TR1 may be formed in a region in which the fin-type active region F1 intersects with the gate line 160. In some implementations, the transistor TR1 may be an n-type metal-oxide-semiconductor (NMOS) transistor. In other implementations, the transistor TR1 may be a p-type metal-oxide-semiconductor (PMOS) transistor.

The first to third nanosheets N1, N2, and N3 in the nanosheet stack NSS may be at different vertical distances (Z-directional distances) from the fin top surface FT of the fin-type active region F1. The number of nanosheet stacks NSS and the number of gate lines 160 on the fin top surface FT of the fin-type active regions F1 are not specifically limited. For example, at least one nanosheet stack NSS and at least one gate line 160 may be on one fin-type active region F1. One nanosheet stack NSS is illustrated as including three nanosheets (i.e., the first to third nanosheets N1, N2, and N3) in FIGS. 2A and 2B, but the number of nanosheets in one nanosheet stack NSS is not specifically limited. For example, each of the nanosheet stacks NSS may include one, two, or at least four nanosheets.

Each of the first to third nanosheets N1, N2, and N3 may constitute a channel region. In some implementations, the first to third nanosheets N1, N2, and N3 may have substantially the same thicknesses as each other in the vertical direction (Z direction). In other implementations, at least some of the first to third nanosheets N1, N2, and N3 may have different thicknesses from each other in the vertical direction (Z direction).

Each of the first to third nanosheets N1, N2, and N3 in the nanosheet NSS may include a multilayered sheet including a first outer semiconductor sheet S1, a core semiconductor sheet S2, and a second outer semiconductor sheet S3, which are sequentially stacked in the vertical direction (Z direction). In each of the first to third nanosheets N1, N2, and N3, a top surface of the first outer semiconductor sheet S1 may be in contact with a bottom surface of the core semiconductor sheet S2, and a top surface of the core semiconductor sheet S2 may be in contact with a bottom surface of the second outer semiconductor sheet S3.

In the multilayered sheet, a constituent material of the core semiconductor sheet S2 may include a different material from a constituent material of each of the first outer semiconductor sheet S1 and the second outer semiconductor sheet S3. In some implementations, in each of the first to third nanosheets N1, N2, and N3, each of the first outer semiconductor sheet S1 and the second outer semiconductor sheet S3 may include a doped Si layer or an undoped Si layer, and the core semiconductor sheet S2 may include a doped SiGe layer or an undoped SiGe layer. When the core semiconductor sheet S2 includes a SiGe layer, a Ge content ratio of the core semiconductor sheet S2 may have a value, which is selected in a range of more than 0 atomic percent (at%) and 20 at% or less.

In some implementations, each of the first to third nanosheets N1, N2, and N3 may be doped with a p-type dopant or an n-type dopant. The p-type dopant may be selected from boron (B) and gallium (Ga) and the n-type dopant may be selected from phosphorus (P), arsenic (As), and antimony (Sb), without being limited thereto.

In some implementations, in each of the first to third nanosheets N1, N2, and N3, respective thicknesses of the first outer semiconductor sheet S1, the core semiconductor sheet S2, and the second outer semiconductor sheet S3 may be the same as each other. In other implementations, in each of the first to third nanosheets N1, N2, and N3, at least some of the first outer semiconductor sheet S1, the core semiconductor sheet S2, and the second outer semiconductor sheet S3 may have different thicknesses from each other.

As shown in FIG. 2C, in the vertical direction (Z direction), the first outer semiconductor sheet S1 may have a first thickness TH1, the core semiconductor sheet S2 may have a second thickness TH2, and the second outer semiconductor sheet S3 may have a third thickness TH3. In some implementations, the first thickness TH1, the second thickness TH2, and the third thickness TH3 may be the same as each other. In other implementations, at least some of the first thickness TH1, the second thickness TH2, and the third thickness TH3 may have different thicknesses from each other.

In some implementations, in a selected one of the first to third nanosheets N1, N2, and N3, the second thickness TH2 of the core semiconductor sheet S2 may be about 20% to about 80% of a thickness of the selected nanosheet in the vertical direction (Z direction). For example, in the vertical direction (Z direction), each of the first to third nanosheets N1, N2, and N3 may have a thickness that is selected in a range of about 4 nm to about 8 nm, and the core semiconductor sheet S2 included in each of the first to third nanosheets N1, N2, and N3 may have a thickness that is selected in a range of about 1 nm to about 6 nm, without being limited thereto.

In some implementations, the first to third nanosheets N1, N2, and N3 included in one nanosheet stack NSS may have the same sizes as each other in the first lateral direction (X direction). In other implementations, at least some of the first to third nanosheets N1, N2, and N3 included in one nanosheet stack NSS may have different sizes from each other in the first lateral direction (X direction). For example, in the first lateral direction (X direction), a length of each of the first and second nanosheets N1 and N2, which are relatively close to the fin top surface FT of the fin-type active region F1, from among the first to third nanosheets N1, N2, and N3, may be greater than a length of the third nanosheet N3, which is farthest from the fin top surface FT of the fin-type active region F1.

The gate line 160 may include a main gate portion 160M and a plurality of sub-gate portions 160S. The main gate portion 160M may cover a top surface of the nanosheet stack NSS and extend long in the second lateral direction (Y direction). The plurality of sub-gate portions 160S may be integrally connected to the main gate portion 160M and respectively arranged between two adjacent ones of the first to third nanosheets N1, N2, and N3 and between the fin top surface FT and the first nanosheet N1.

The gate line 160 may include a metal, a metal nitride, a metal carbide, or a combination thereof. The metal may be selected from titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). The metal nitride may be selected from titanium nitride (TiN) and tantalum nitride (TaN). The metal carbide may include titanium aluminum carbide (TiAlC). In some implementations, the gate line 160 may have a structure in which a metal nitride film, a metal film, a conductive capping film, and a gap-fill metal film are sequentially stacked. The metal nitride film and the metal film may include at least one metal selected from titanium (Ti), tantalum (Ta), tungsten (W), ruthenium (Ru), niobium (Nb), molybdenum (Mo), and hafnium (Hf). The gap-fill metal film may include tungsten (W), aluminum (Al), or a combination thereof. The gate line 160 may include at least one work-function metal-containing film. The at least one work-function metal-containing film may include at least one metal selected from Ti, W, Ru, Nb, Mo, Hf, Ni, Co, Pt, Yb, Tb, Dy, Er, and Pd. In some implementations, the gate line 160 may have a stack structure of at least two layers selected from a first work-function metal-containing film, a second work-function metal-containing film, and a gap-fill metal film. For example, the first work-function metal-containing film may include a titanium nitride (TiN) film. The second work-function metal-containing film may include a combination of a first TiN film, a titanium aluminum carbide (TiAlC) film, and a second TiN film. In some implementations, the gate line 160 may include a TiN film, a stack structure of TiAlC/TiN/W, a stack structure of TiN/TaN/TiAlC/TiN/W, or a stack structure of TiN/TaN/TiN/TiAlC/TiN/W. However, a constituent material of the gate line 160 is not limited to the examples described above and may be variously modified and changed within the scope of the inventive concept.

As shown in FIG. 2A, a plurality of recesses R1 may be formed in the fin-type active region F1 on both sides of the gate line 160. FIG. 2A illustrate an example in which the lowermost surface of each of the plurality of recesses R1 is at a lower level than the fin top surface FT of the fin-type active region F1, but the inventive concept is not limited thereto. The lowermost surface of each of the plurality of recesses R1 may substantially be at the same level as the fin top surface FT of the fin-type active region F1. As used herein, the term "vertical level" refers to a distance from a main surface 102M of the substrate 102 in the vertical direction (Z direction or -Z direction).

A pair of source/drain regions 130 may be on the plurality of recesses R1. The pair of source/drain regions 130 may be respectively on both sides of the gate line 160 on the fin-type active region F1. The pair of source/drain regions 130 may be in contact with each of the first to third nanosheets N1, N2, and N3. The pair of source/drain regions 130 may be in contact with the first outer semiconductor sheet S1, the core semiconductor sheet S2, and the second outer semiconductor sheet S3 in each of the first to third nanosheets N1, N2, and N3. In the implementations illustrated in FIG. 2A and other implementations described in this disclosure, the phrase source/drain region may be understood to mean a source terminal region or a drain terminal region of a transistor.

When the transistor TR1 is a PMOS transistor region, the pair of source/drain regions 130 may include a SiGe layer doped with a p-type dopant. When the transistor TR1 is an NMOS transistor region, the pair of source/drain regions 130 may include a Si layer doped with an n-type dopant or a SiC layer doped with an n-type dopant. Examples of each of the p-type dopant and the n-type dopant are the same as described above.

A gate dielectric film 152 may be between the first to third nanosheets N1, N2, and N3 included in the nanosheet stack NSS and the gate line 160. The gate dielectric film 152 may include portions respectively covering the first to third nanosheets N1, N2, and N3 and portions covering sidewalls of the main gate portion 160M. The gate dielectric film 152 may be in contact with the first and second outer semiconductor sheets S1 and S3 of each of the first to third nanosheets N1, N2, and N3 and apart from the core semiconductor sheet S2 of each of the first to third nanosheets N1, N2, and N3 in the vertical direction (Z direction).

The gate dielectric film 152 may have a stack structure of an interface film and a high-k dielectric film. The interface film may include a low-k dielectric material film (e.g., a silicon oxide film, a silicon oxynitride film, or a combination thereof), which has a dielectric constant of 9 or less. In some implementations, the interface film may be omitted. The high-k dielectric film may include a material having a higher dielectric constant than a silicon oxide film. For example, the high-k dielectric film may have a dielectric constant of about 10 to about 25. The high-k dielectric film may include hafnium oxide, without being limited thereto.

As shown in FIG. 2A, both sidewalls of the gate line 160 may be covered by outer insulating spacers 118. The outer insulating spacers 118 may extend long in the second lateral direction (Y direction) on the fin-type active region F1 and the device isolation film 112. The outer insulating spacers 118 may include a portion covering both sidewalls of the main gate portion 160M on the top surface of the nanosheet stack NSS and a portion covering the gate line 160 on the device isolation film 112. The outer insulating spacers 118 may be apart from the gate line 160 with the gate dielectric film 152 therebetween. The outer insulating spacers 118 may include silicon nitride, silicon oxide, silicon carbonitride (SiCN), silicon boron nitride (SiBN), silicon oxynitride (SiON), silicon oxycarbonitride (SiOCN), silicon boron carbonitride (SiBCN), silicon oxycarbide (SiOC), or a combination thereof. As used herein, each of the terms "SiCN," "SiBN," "SiON," "SiOCN," "SiBCN," and "SiOC" refers to a material including elements included therein, without referring to a chemical formula representing a stoichiometric relationship.

Between two adjacent ones of the first to third nanosheets N1, N2, and N3 and between the fin-type active region F1 and the first nanosheet N1, both sidewalls of each of the plurality of sub-gate portions 160S may be apart from the pair of source/drain regions 130 with the gate dielectric film 152 therebetween. Each of the pair of source/drain regions 130 may face the nanosheet stack NSS and the plurality of sub-gate portions 160S in the first lateral direction (X direction).

A top surface of each of the gate line 160, the gate dielectric film 152, and the outer insulating spacers 118 may be covered by a capping insulating pattern 164. The capping insulating pattern 164 may include a silicon nitride film. The main gate portion 160M of the gate line 160 may be apart from the pair of source/drain regions 130 with the outer insulating spacers 118 therebetween.

The pair of source/drain regions 130 may be covered by an insulating liner 142. The insulating liner 142 may conformally cover a surface of each of the pair of source/drain regions 130 and the outer insulating spacers 118. The insulating liner 142 may include SiN, SiCN, SiBN, SiON, SiOCN, SiBCN, SiOC, SiO₂, or a combination thereof. The insulating liner 142 may be covered by an inter-gate dielectric film 144. The inter-gate dielectric film 144 may include a silicon oxide film, a silicon nitride film, SiON, SiOCN, or a combination thereof.

The IC device 100 described with reference to FIGS. 1 and 2A to 2C may include the nanosheet stack NSS including the first to third nanosheets N1, N2, and N3 as a channel region of the transistor TR1, and each of the first to third nanosheets N1, N2, and N3 may include the multilayered sheet including the first outer semiconductor sheet S1, the core semiconductor sheet S2, and the second outer semiconductor sheet S3, which are sequentially stacked in the vertical direction (Z direction). In the multilayered sheet, a constituent material of the core semiconductor sheet S2 may be different from a constituent material of each of the first outer semiconductor sheet S1 and the second outer semiconductor sheet S3. In the IC device 100, to adjust a threshold voltage of the transistor TR1, a content ratio and/or a thickness of a semiconductor material included in each of the first outer semiconductor sheet S1, the core semiconductor sheet S2, and the second outer semiconductor sheet S3 included in the multilayered sheet may vary. For example, when each of the first outer semiconductor sheet S1 and the second outer semiconductor sheet S3 includes a doped Si layer or an undoped Si layer, the core semiconductor sheet S2 may include a doped SiGe layer or an undoped SiGe layer. In this case, by controlling a Ge content ratio of the SiGe layer or controlling a relative thickness of the SiGe layer in each of the first to third nanosheets N1, N2, and N3, the threshold voltage of the transistor TR1 may be adjusted within a desired range. In some implementations, when the core semiconductor sheet S2 includes a SiGe layer, the threshold voltage of the transistor TR1 may be reduced as the Ge content ratio of the SiGe layer increases. In some implementations, when the core semiconductor sheet S2 includes a SiGe layer, the threshold voltage of the transistor TR1 may be reduced as the thickness of the SiGe layer increases. As described above, by controlling a content ratio and/or a relative thickness of a constituent material of the core semiconductor sheet S2 in each of the first to third nanosheets N1, N2, and N3, a required threshold voltage of the transistor TR1 may be precisely controlled. Accordingly, the reliability of the IC device 100 may improve.

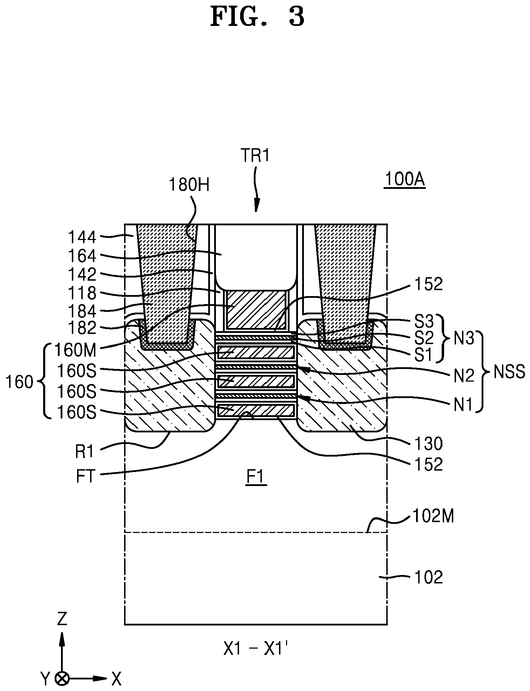

FIG. 3 is a cross-sectional view of an IC device 100A according to some implementations. FIG. 3 illustrates some components in a portion corresponding to a cross-section taken along line X1-X1' of FIG. 1. In FIG. 3, the same reference numerals are used to denote the same elements as in FIGS. 1 and 2A to 2C, and repeated descriptions thereof are omitted.

Referring to FIG. 3, the IC device 100A may have substantially the same configurations as the IC device 100 described with reference to FIGS. 1 and 2A to 2C. However, the IC device 100A may further include a pair of source/drain contacts 184 on a pair of source/drain regions 130. Each of the pair of source/drain contacts 184 may extend long the vertical direction (Z direction) on the source/drain region 130. A metal silicide film 182 may be between the source/drain region 130 and the source/drain contact 184. Each of the pair of source/drain regions 130 may be apart from the source/drain contact 184 with the metal silicide film 182 therebetween. Each of the pair of source/drain contacts 184 may be connected to the source/drain region 130 through the metal silicide film 182. Each of the pair of source/drain contacts 184 may fill a contact hole 180H, which passes through an inter-gate dielectric film 144 and an insulating liner 142 in the vertical direction (Z direction) and extends into the source/drain region 130. Each of the pair of source/drain regions 130 may surround a bottom portion of the source/drain contact 184.

In some implementations, each of the pair of source/drain contacts 184 may include a metal, a conductive metal nitride, or a combination thereof. For example, each of the pair of source/drain contacts 184 may include W, Mo, Cu, Al, Ti, Ta, TiN, TaN, an alloy thereof, or a combination thereof. In some implementations, the metal silicide film 182 may include titanium silicide, without being limited thereto.

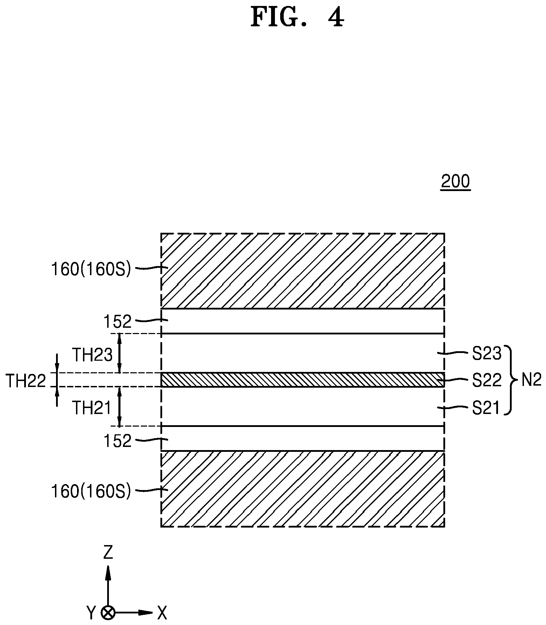

FIG. 4 is a cross-sectional view of an IC device 200 according to some implementations. FIG. 4 illustrates an enlarged cross-sectional configuration of some components in a region corresponding to local region "EX1" of FIG. 2A in the IC device 200. In FIG. 4, the same reference numerals are used to denote the same elements as in FIGS. 1 and 2A to 2C, and repeated descriptions thereof are omitted.

Referring to FIG. 4, the IC device 200 may have substantially the same configurations as the IC device 100 described with reference to FIGS. 1 and 2A to 2C. Similar to that described with reference to FIGS. 2A to 2C, the IC device 200 may include a nanosheet stack NSS including a first nanosheet N1, a second nanosheet N2, and a third nanosheet N3. However, in the IC device 200, each of the first to third nanosheets N1, N2, and N3 may include a multilayered sheet including a first outer semiconductor sheet S21, a core semiconductor sheet S22, and a second outer semiconductor sheet S23, which are sequentially stacked in a vertical direction (Z direction). In each of the first to third nanosheets N1, N2, and N3, a top surface of the first outer semiconductor sheet S21 may be in contact with a bottom surface of the core semiconductor sheet S22 and a top surface of the core semiconductor sheet S22 may be in contact with a bottom surface of the second outer semiconductor sheet S23.

Details of the first outer semiconductor sheet S21, the core semiconductor sheet S22, and the second outer semiconductor sheet S23 may be substantially the same as those of the first outer semiconductor sheet S1, the core semiconductor sheet S2, and the second outer semiconductor sheet S3 described with reference to FIGS. 2A to 2C. However, in the vertical direction (Z direction), the first outer semiconductor sheet S21 may have a first thickness TH21, the core semiconductor sheet S22 may have a second thickness TH22, and the second outer semiconductor sheet S23 may have a third thickness TH23. Here, the second thickness TH22 may be less than each of the first thickness TH21 and the third thickness TH23. In some implementations, the first thickness TH21 may be equal to the third thickness TH23. In other implementations, the first thickness TH21 may be different from the third thickness TH23.

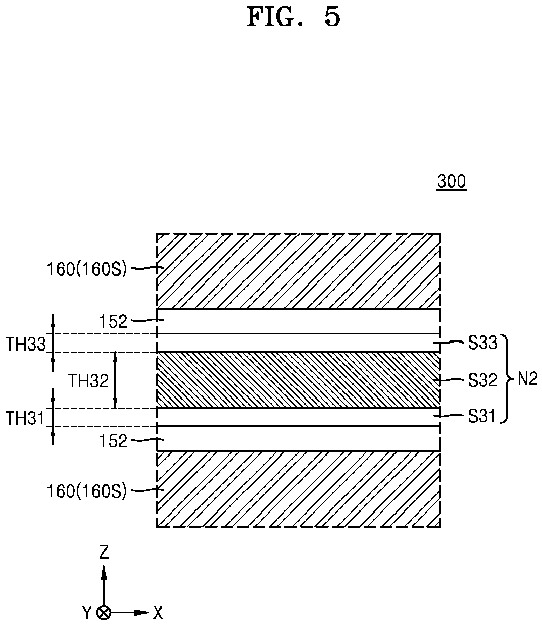

FIG. 5 is a cross-sectional view of an IC device 400 according to some implementations. FIG. 5 illustrates an enlarged cross-sectional configuration of some components in a region corresponding to the local region "EX1" of FIG. 2A in the IC device 300. In FIG. 5, the same reference numerals are used to denote the same elements as in FIGS. 1 and 2A to 2C, and repeated descriptions thereof are omitted.

Referring to FIG. 5, the IC device 300 may have substantially the same configurations as the IC device 100 described with reference to FIGS. 1 and 2A to 2C. Similar to the description provided with reference to FIGS. 2A to 2C, the IC device 300 may include a nanosheet stack NSS including a first nanosheet N1, a second nanosheet N2, and a third nanosheet N3. However, in the IC device 300, each of the first to third nanosheets N1, N2, and N3 may include a multilayered sheet, which includes a first outer semiconductor sheet S31, a core semiconductor sheet S32, and a second outer semiconductor sheet S33, which are sequentially stacked in the vertical direction (Z direction). In each of the first to third nanosheets N1, N2, and N3, a top surface of the first outer semiconductor sheet S31 may be in contact with a bottom surface of the core semiconductor sheet S32, and a top surface of the core semiconductor sheet S32 may be in contact with a bottom surface of the second outer semiconductor sheet S33.

Details of the first outer semiconductor sheet S31, the core semiconductor sheet S32, and the second outer semiconductor sheet S33 are substantially the same as those of the first outer semiconductor sheet S1, the core semiconductor sheet S2, and the second outer semiconductor sheet S3, which have been described with reference to FIGS. 2A to 2C. However, in the vertical direction (Z direction), the first outer semiconductor sheet S31 may have a first thickness TH31, the core semiconductor sheet S32 may have a second thickness TH32, and the second outer semiconductor sheet S33 may have a third thickness TH33. Here, the second thickness TH32 may be greater than each of the first thickness TH31 and the third thickness TH33. In some implementations, the first thickness TH31 may be equal to the third thickness TH33. In other implementations, the first thickness TH31 may be different from the third thickness TH33.

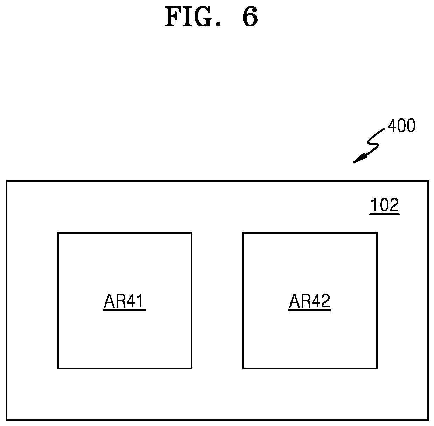

FIG. 6 is a block diagram of an IC device 400 according to some implementations.

Referring to FIG. 6, the IC device 400 may include a substrate 102 having a first region AR41 and a second region AR42. The first and second regions AR41 and AR42 may refer to different regions of the substrate 102.

In some implementations, the first and second regions AR41 and AR42 may be regions in which different threshold voltages are required. In an example, the first and second regions AR41 and AR42 may be NMOS transistor regions. In another example, the first and second regions AR41 and AR42 may include PMOS transistor regions. In still another example, the first region AR41 may be an NMOS transistor region and the second region AR42 may be a PMOS transistor region. In yet another example, the first region AR41 may be a PMOS transistor region and the second region AR42 may be an NMOS transistor region.

In some implementations, the first and second regions AR41 and AR42 may be regions configured to perform different functions from each other. The first and second regions AR41 and AR42 may be regions separated from each other or regions connected to each other.

In some implementations, each of the first and second regions AR41 and AR42 may be an NMOS transistor region. The first region AR41 may be a low-voltage NMOS transistor region in which a lower threshold voltage is required than in the second region AR42, and the second region AR42 may be a high-voltage NMOS transistor region in which a higher threshold voltage is required than in the first region AR41. In other implementations, each of the first and second regions AR41 and AR42 may be a PMOS transistor region, the first region AR41 may be a low-voltage PMOS transistor region in which a lower threshold voltage is required than in the second region AR42, and the second region AR42 may be a high-voltage PMOS transistor region in which a higher threshold voltage is required than in the first region AR41. As used herein, the terms "low voltage" and "high voltage" may be relative terms. Unless otherwise defined, the "low voltage" refers to a voltage lower than a voltage to be compared and the "high voltage" refers to a voltage higher than a voltage to be compared.

In some implementations, each of the first and second regions AR41 and AR42 may be independently a logic cell region, a memory cell region, or a peripheral circuit region.

In some implementations, the first region AR41 may be a region in which a transistor having a relatively low threshold voltage and a high switching speed is formed. In some implementations, at least one of the first and second regions AR41 and AR42 may be a cell array region in which unit memory cells are arranged in a matrix form. In some implementations, at least one of the first and second regions AR41 and AR42 may be a logic cell region or a memory cell region. The logic cell region may include standard cells configured to perform desired logical functions, such as counters and buffers. The standard cells may include various kinds of logic cells including a plurality of circuit elements, such as transistors and registers. Each of the logic cells may constitute, for example, an AND, a NAND, an OR, a NOR, an exclusive OR (XOR), an exclusive NOR (XNOR), an inverter (INV), an adder (ADD), a buffer (BUF), a delay (DLY), a filter (FIL), a multiplexer (MXT/MXIT), an OR/AND/INVERTER (OAI), an AND/OR (AO), an AND/OR/INVERTER (AOI), a D-flip-flop, a reset flip-flop, a master-slave flip-flop, or a latch, without being limited thereto. The memory cell region may be a memory cell region of at least one of static random access memory (SRAM), dynamic RAM (DRAM), magnetic RAM (MRAM), resistive RAM (RRAM), and phase-change RAM (PRAM).

Each of the IC devices 100, 100A, 200, and 300 described with reference to FIGS. 1 to 5 or IC devices having structures formed by making various modifications and changes within the scope of the inventive concept may be formed in at least one of the first and second regions AR41 and AR42 shown in FIG. 6. In some implementations, each of the first and second regions AR41 and AR42 shown in FIG. 6 may include a transistor TR1 of the IC device 100 described with reference to FIGS. 1 and 2A to 2C, and a core semiconductor sheet S2 of each of a first nanosheet N1, a second nanosheet N2, and a third nanosheet N3, which constitute a channel region of the transistor TR1 in each of the first and second regions AR41 and AR42, may include a SiGe layer. However, a Ge content ratio of the SiGe layer included in the core semiconductor sheet S2 of the transistor TR1 in the first region AR41 may be different from a Ge content ratio of the SiGe layer included in the core semiconductor sheet S2 of the transistor TR1 in the second region AR42. For example, when a threshold voltage required in the transistor TR1 in the first region AR41 is lower than a threshold voltage required in the transistor TR1 in the second region AR42, the Ge content ratio of the SiGe layer included in the core semiconductor sheet S2 of the transistor TR1 in the first region AR41 may be greater than the Ge content ratio of the SiGe layer included in the core semiconductor sheet S2 of the transistor TR1 in the second region AR42.

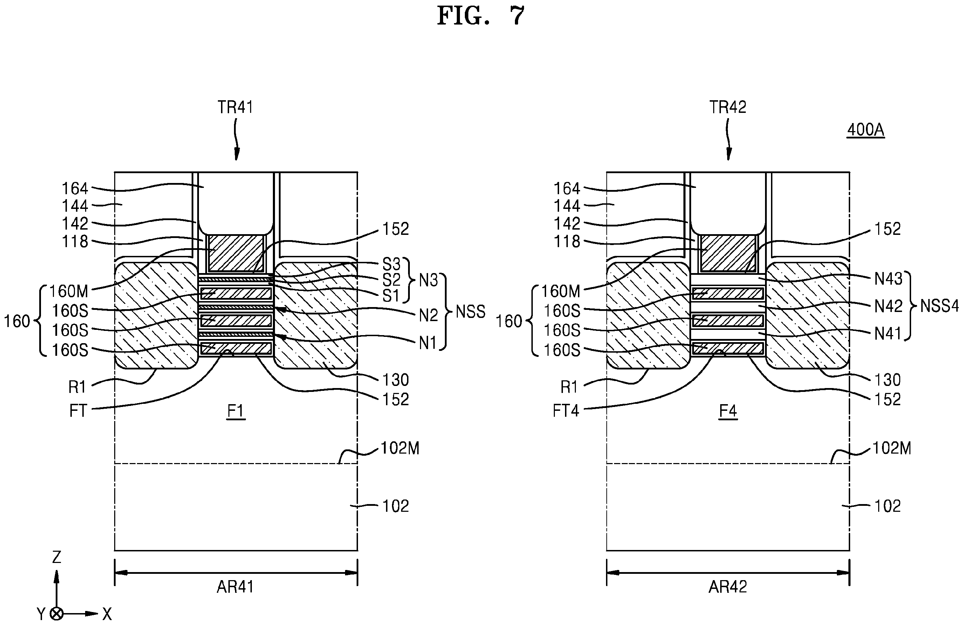

FIG. 7 is a cross-sectional view of an IC device 400A according to some implementations. In FIG. 7, the same reference numerals are used to denote the same elements as in FIGS. 1, 2A to 2C, and 6, and repeated descriptions thereof are omitted.

Referring to FIG. 7, a substrate 102 of the IC device 400A may have a first region AR41 and a second region AR42. A first transistor TR41 may be in the first region AR41 of the substrate 102 and a second transistor TR42 may be in the second region AR42 of the substrate 102.

The first transistor TR41 in the first region AR41 may have the same configurations as the transistor TR1 described with reference to FIGS. 1 and 2A to 2C. In the first transistor TR41, each of a first nanosheet N1, a second nanosheet N2, and a third nanosheet N3, which are in a nanosheet stack NSS that provides a channel region, may include a multilayered sheet including a first outer semiconductor sheet S1, a core semiconductor sheet S2, and a second outer semiconductor sheet S3. As used herein, each of the first to third nanosheets N1, N2, and N3 that constitute the first transistor TR41 in the first region AR41 may be referred to as a first-type nanosheet, the fin-type active region F1 in the first region AR41 may be referred to as a first fin-type active region, a gate line 160 in the first region AR41 may be referred to as a first gate line, and the source/drain region 130 in the first region AR41 may be referred to as a first source/drain region.

The second transistor TR42 in the second region AR42 may have substantially the same configurations as the transistor TR1 described with reference to FIGS. 1 and 2A to 2C except that the second transistor TR42 includes a nanosheet stack NSS4 instead of the nanosheet stack NSS shown in FIGS. 2A to 2C.

In the second transistor TR42 in the second region AR42, the nanosheet stack NSS4 that provides a channel region may include a first nanosheet N41, a second nanosheet N42, and a third nanosheet N43, which overlap each other in the vertical direction (Z direction) on a fin top surface FT4 of the fin-type active region F4. The first to third nanosheets N41, N42, and N43 may be at different vertical distances (Z-directional distances) from the fin top surface FT4 of the fin-type active region F4. Details of the fin-type active region F4 may be substantially the same as those of the fin-type active region F1 described with reference to FIGS. 1 and 2A to 2C.

The first to third nanosheets N41, N42, and N43 that constitute the nanosheet stack NSS4 may have substantially the same configurations as the first to third nanosheets N1, N2, and N3 described with reference to FIGS. 2A to 2C. However, each of the first to third nanosheets N41, N42, and N43 may include a single sheet including a Si layer. In some implementations, each of the first to third nanosheets N41, N42, and N43 may include a single sheet including a Si layer doped with an n-type dopant. In other implementations, each of the first to third nanosheets N41, N42, and N43 may include a single sheet including a Si layer doped with a p-type dopant. Each of the first to third nanosheets N41, N42, and N43 may not include a SiGe layer.

As used herein, each of the first to third nanosheets N41, N42, and N43 that constitute the second transistor TR42 in the second region AR42 may be referred to as a second-type nanosheet, the fin-type active region F4 in the second region AR42 may be referred to as a second fin-type active region, a gate line 160 in the second region AR42 may be referred to as a second gate line, and the source/drain region 130 in the second region AR42 may be referred to as a second source/drain region.

In the IC device 400A shown in FIG. 7, a threshold voltage of the first transistor TR41 in the first region AR41 may be lower than a threshold voltage of the second transistor TR42 in the second region AR42.

In other implementations, differently from the illustration of FIG. 7, the channel region of the second transistor TR42 in the second region AR42 may have the same structure as the nanosheet stack NSS that provides the channel region of the first transistor TR41 in the first region AR41. That is, each of the first transistor TR41 located in the first region AR41 and the second transistor TR41 located in the second region AR42 may include, as the channel region, a nanosheet stack NSS including a first nanosheet N1, a second nanosheet N2, and a third nanosheet N3. Each of the first to third nanosheets N1, N2, and N3 that provide the channel region of each of the first and second transistors TR41 and TR42 may include a multilayered sheet, which includes a first outer semiconductor sheet S1, a core semiconductor sheet S2, and a second outer semiconductor sheet S3 that are sequentially stacked in the vertical direction (Z direction). Herein, in each of the first to third nanosheets N1, N2, and N3 that provide the channel region of each of the first and second transistors TR41 and TR42, the core semiconductor sheet S2 may include a SiGe layer. Also, a Ge content ratio of the core semiconductor sheet S2 that constitutes the channel region of the first transistor TR41 in the first region AR41 may be different from a Ge content ratio of the core semiconductor sheet S2 that constitutes the channel region of the second transistor TR42 in the second region AR42.

For example, in each of the first to third nanosheets N1, N2, and N3 that provide the channel region of each of the first and second transistors TR41 and TR42, the core semiconductor sheet S2 may include a SiGe layer. Also, a Ge content ratio of the core semiconductor sheet S2 that constitutes the channel region of the first transistor TR41 in the first region AR41 may be higher than a Ge content ratio of the core semiconductor sheet S2 that constitutes the channel region of the second transistor TR42 in the second region AR42. In the configuration described above, a threshold voltage of the first transistor TR41 in the first region AR41 may become lower than a threshold voltage of the second transistor TR42 in the second region AR42.

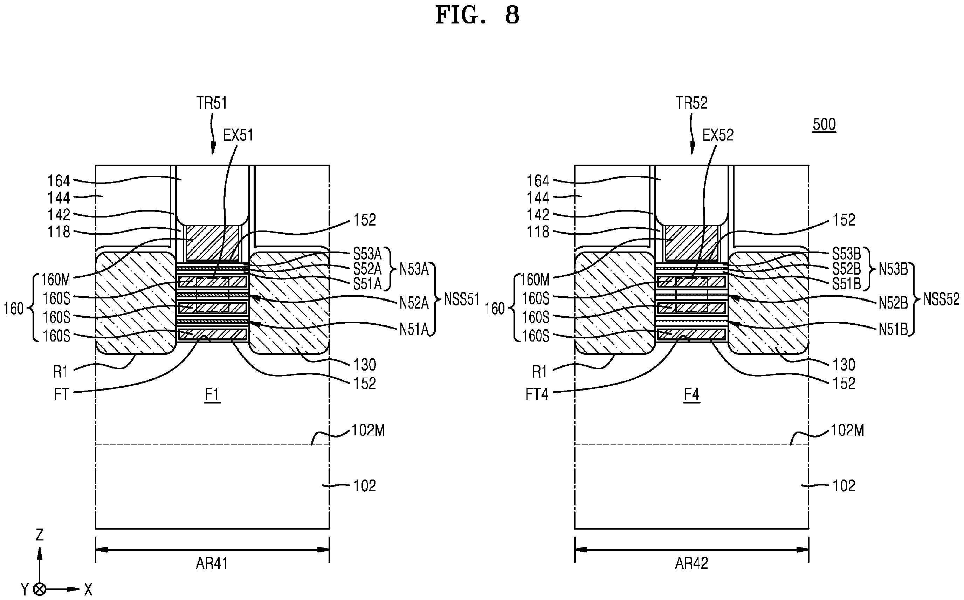

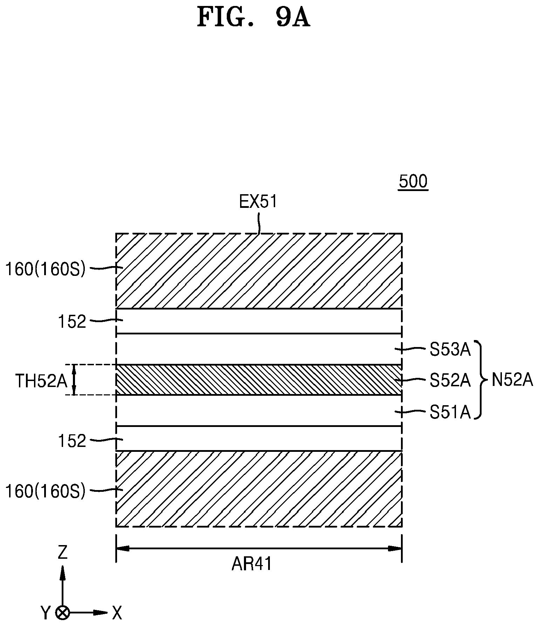

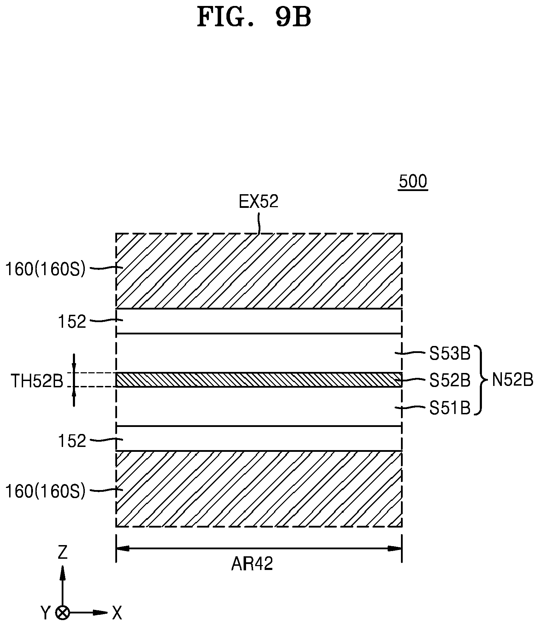

FIG. 8 is a cross-sectional view of an IC device 500 according to some implementations. FIG. 9A is an enlarged cross-sectional view of some components in local region "EX51" of FIG. 8, and FIG. 9B is an enlarged cross-sectional view of some components in local region "EX52" of FIG. 8.

In FIGS. 8, 9A, and 9B, the same reference numerals are used to denote the same elements as in FIGS. 1, 2A to 2C, 6, and 7, and repeated descriptions thereof are omitted.

Referring to FIGS, 8, 9A, and 9B, the IC device 500 may have substantially the same configuration as the IC device 400A described with reference to FIG. 7. A substrate 102 of the IC device 500 may have a first region AR41 and a second region AR42. However, in the IC device 500, a first transistor TR51 may be in the first region AR41 of the substrate 102 and a second transistor TR52 may be in the second region AR42 of the substrate 102.

Each of the first transistor TR51 and the second transistor TR52 may have the same configuration as the transistor TR1 described with reference to FIGS. 1 and 2A to 2C. However, the first transistor TR51 may include a nanosheet stack NSS51 that provides a channel region and the second transistor TR52 may include a nanosheet stack NSS52 that provides a channel region.

The nanosheet stack NSS51 of the first transistor TR51 in the first region AR41 may include a first nanosheet N51A, a second nanosheet N52A, and a third nanosheet N53A. Each of the first to third nanosheets N51A, N52A, and N53A may include a multilayered sheet including a first outer semiconductor sheet S51A, a core semiconductor sheet S52A, and a second outer semiconductor sheet S53A, which are sequentially stacked in a vertical direction (Z direction). As used herein, the first to third nanosheets N51A, N52A, and N53A that constitute the first transistor TR51 in the first region AR41 may be referred to as a first-type nanosheet.

The nanosheet stack NSS52 of the second transistor TR52 in the second region AR42 may include a first nanosheet N51B, a second nanosheet N52B, and a third nanosheet N53B. Each of the first to third nanosheets N51B, N52B, and N53B may include a multilayered sheet including a first outer semiconductor sheet S51B, a core semiconductor sheet S52B, and a second outer semiconductor sheet S53B, which are sequentially stacked in the vertical direction (Z direction). As used herein, the first to third nanosheets N51B, N52B, and N53B that constitute the second transistor TR52 in the second region AR42 may be referred to as a second-type nanosheet.

The first outer semiconductor sheet S51A and the second outer semiconductor sheet S53A, which are in the first region AR41, and the first outer semiconductor sheet S51B and the second outer semiconductor sheet S53B, which are in the second region AR42, may each include a doped Si layer or an undoped Si layer. In addition, each of the core semiconductor sheet S52A in the first region AR41 and the core semiconductor sheet S52B in the second region AR42 may include a doped SiGe layer or an undoped SiGe layer. Details of the doped Si layer and the doped SiGe layer may be the same as those described with reference to FIGS. 2A to 2C.

A first thickness TH52A of the core semiconductor sheet S52A in the first region AR41 may be different from a second thickness TH52B of the core semiconductor sheet S52B in the second region AR42. For example, the first thickness TH52A and the second thickness TH52B may have different values, each of which is selected in a range of about 1 nm to about 6 nm. FIGS. 8, 9A, and 9B illustrate a configuration in which the first thickness TH52A is greater than the second thickness TH52B. In the configuration described above, a threshold voltage of the first transistor TR51 in the first region AR41 may become lower than a threshold voltage of the second transistor TR52 in the second region AR42.

In some implementations, a Ge content ratio of a SiGe layer included in the core semiconductor sheet S52A in the first region AR41 may be equal to a Ge content ratio of a SiGe layer included in the core semiconductor sheet S52B in the second region AR42. For example, the Ge content ratio of the SiGe layer included in the core semiconductor sheet S52A in the first region AR41 and the Ge content ratio of the SiGe layer included in the core semiconductor sheet S52B in the second region AR42 may have the same value, which is selected in a range of more than 0 at% and 20 at% or less.

In other implementations, a Ge content ratio of the SiGe layer included in the core semiconductor sheet S52A in the first region AR41 may be greater than a Ge content ratio of the SiGe layer included in the core semiconductor sheet S52B in the second region AR42. In the configuration described above, a threshold voltage of the first transistor TR51 in the first region AR41 may become lower than a threshold voltage of the second transistor TR52 in the second region AR42.

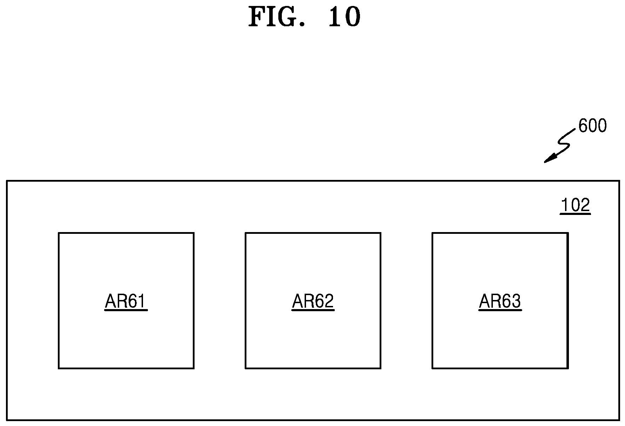

FIG. 10 is a block diagram of an IC device 600 according to some implementations.

Referring to FIG. 10, the IC device 600 may include a substrate 102 having a first region AR61, a second region AR62, and a third region AR63. The first to third regions AR61, AR62, and AR63 refer to different regions of the substrate 102.

The first to third regions AR61, AR62, and AR63 may be regions that require different threshold voltages. In some implementations, at least one of the first to third regions AR61, AR62, and AR63 may be an NMOS transistor region. In other implementations, at least one of the first to third regions AR61, AR62, and AR63 may include a PMOS transistor region.

The first to third regions AR61, AR62, and AR63 may be regions configured to perform different functions. At least some of the first to third regions AR61, AR62, and AR63 may be regions that are apart from each other or connected to each other.

In some implementations, each of the first to third regions AR61, AR62, and AR63 may be an NMOS transistor region. In this case, the first region AR61 may be a low-voltage NMOS transistor region in which a lower threshold voltage is required than in the second region AR2 and the third region AR63 may be a high-voltage NMOS transistor region in which a higher threshold voltage is required than in the first region AR61. The second region AR62 may be a middle voltage NMOS transistor region in which a higher threshold voltage is required than in the first region AR61 and a lower threshold voltage is required than in the third region AR63.

In other implementations, each of the first to third regions AR61, AR62, and AR63 may be a PMOS transistor region. In this case, the first region AR61 may be a high-voltage PMOS transistor region in which a higher threshold voltage is required than in the second region AR62 and the third region AR63 may be a low-voltage PMOS transistor region in which a lower threshold voltage is required than in the first region AR1. The second region AR62 may be a middle voltage PMOS transistor region in which a lower threshold voltage is required than in the first region AR61 and a higher threshold voltage is required than in the third region AR63.

In some implementations, each of the first to third regions AR61, AR62, and AR63 may be independently a logic cell region, a memory cell region, or a peripheral circuit region.

In some implementations, at least one of the first to third regions AR61, AR62, and AR63 may be a region in which a transistor having a relatively high threshold voltage and high reliability is formed even if the switching speed of the transistor is not high. In some implementations, at least one of the first to third regions AR61, AR62, and AR63 may be a peripheral circuit region in which peripheral circuits configured to input external data to an internal circuit of the IC device 600 or output data from the internal circuit of the IC device 600 to the outside are formed. In some implementations, at least one of the first to third regions AR61, AR62, and AR63 may constitute a portion of an input/output (I/O) circuit device.

In other implementations, at least one of the first to third regions AR61, AR62, and AR63 may be a region in which a transistor having a relatively low threshold voltage and a high switching speed is formed. In some implementations, at least one of the first to third regions AR61, AR62, and AR63 may be a cell array region in which unit memory cells are arranged in a matrix form. In some implementations, at least one of the first to third regions AR61, AR62, and AR63 may be a logic cell region or a memory cell region.

Each of the IC devices 100, 100A, 200, 300, 400, 400A, and 500 shown in FIGS. 1 to 9B and IC devices having structures formed by making various modifications and changes within the scope of the inventive concept may be formed in at least one of the first to third regions AR61, AR62, and AR63 shown in FIG. 10.

FIGS. 11A to 17B are cross-sectional views of an IC device being manufactured according to a process sequence of a method,, according to some implementations. More specifically, FIGS. 11A, 12A, 13A, 14A, 15A, 16A, and 17A are cross-sectional views of some components in a portion corresponding to the cross-section taken along line X1 - X1' of FIG. 1, according to the process sequence. FIGS. 11B, 12B, 13B, 14B, 15B, 16B, and 17B are cross-sectional views of some components in a portion corresponding to the cross-section taken along the line Y1 - Y1' of FIG. 1, according to the process sequence. FIG. 11C is an enlarged cross-sectional view of some components in local region "EXA" of FIG. 11A. An example of the method of manufacturing the IC device 100 shown in FIGS. 1 and 2A to 2C is described with reference to FIGS. 11A to 17B. In FIGS. 11A to 17B, the same reference numerals are used to denote the same elements as in FIGS. 1 and 2A to 2C, and repeated descriptions thereof are omitted.

Referring to FIGS. 11A, 11B, and 11C, a stack structure in which a plurality of sacrificial semiconductor layers 104 and a plurality of nanosheet semiconductor layers NS are alternately stacked one-by-one may be formed on a substrate 102, and a mask pattern MP may be formed on the stack structure.

Each of the plurality of nanosheet semiconductor layers NS may include a multilayered sheet including a first outer semiconductor sheet S1, a core semiconductor sheet S2, and a second outer semiconductor sheet S3. The mask pattern MP may have a double structure of a silicon oxide film M1 and a silicon nitride film M2.

The plurality of sacrificial semiconductor layers 104 and the plurality of nanosheet semiconductor layers NS may include semiconductor materials having different etch selectivities from each other. In some implementations, in each of the plurality of nanosheet semiconductor layers NS, each of the first outer semiconductor sheet S1 and the second outer semiconductor sheet S3 may include a doped Si layer or an undoped Si layer, and the core semiconductor sheet S2 may include a doped SiGe layer or an undoped SiGe layer. When the core semiconductor sheet S2 includes a SiGe layer, a Ge content ratio of the core semiconductor sheet S2 may have a value, which is selected in a range of more than 0 at% and 20 at% or less. Each of the plurality of sacrificial semiconductor layers 104 may include a SiGe layer, and a content ratio of the SiGe layer in each of the plurality of sacrificial semiconductor layers 104 may be higher than the Ge content ratio of the core semiconductor sheet S2. In some implementations, the SiGe layer included in the plurality of sacrificial semiconductor layers 104 may have a constant Ge content, which is selected in a range of about 25 at% to about 60 at%, for example, about 30 at% to about 40 at%. The Ge concentration of the SiGe layer included in the plurality of sacrificial semiconductor layers 104 may be variously selected as needed.

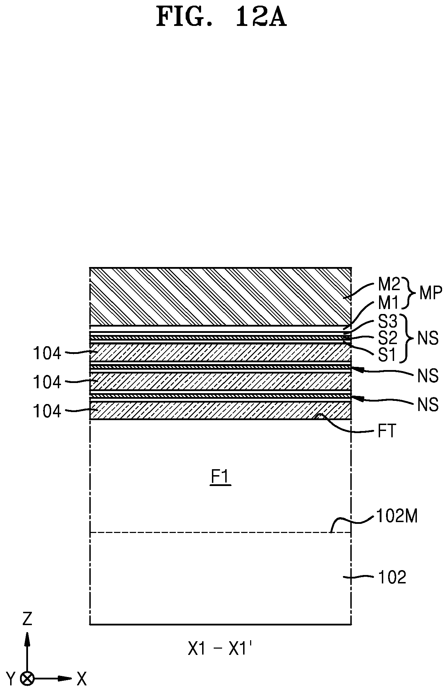

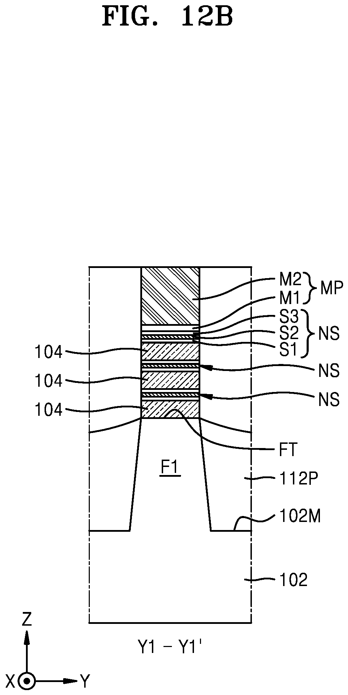

Referring to FIGS. 12A and 12B, respective portions of the plurality of sacrificial semiconductor layers 104, the plurality of nanosheet semiconductor layers NS, and the substrate 102 may be etched by using the mask pattern MP as an etch mask. Thus, a fin-type active region F1 that protrudes from the substrate 102 upward in the vertical direction (Z direction) and extends in a first lateral direction (X direction) may be formed. The stack structure in which the plurality of sacrificial semiconductor layers 104 and the plurality of nanosheet semiconductor layers NS are alternately stacked one-by-one and the mask pattern MP may remain on the fin-type active region F1.

Thereafter, a preliminary device isolation film 112P may be formed to fill respective spaces between a plurality of fin-type active regions F1 and openings formed in the mask pattern MP. The resultant structure including the preliminary device isolation film 112P may be planarized by using a chemical mechanical polishing (CMP) process such that a top surface of the preliminary device isolation film 112P is coplanar with a top surface of the mask pattern MP. A constituent material of the preliminary device isolation film 112P may be the same as that of the device isolation film 112, which has been described with reference to FIG. 2B.

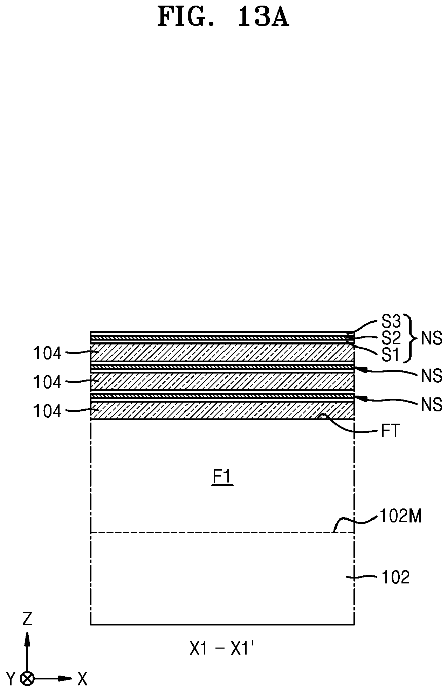

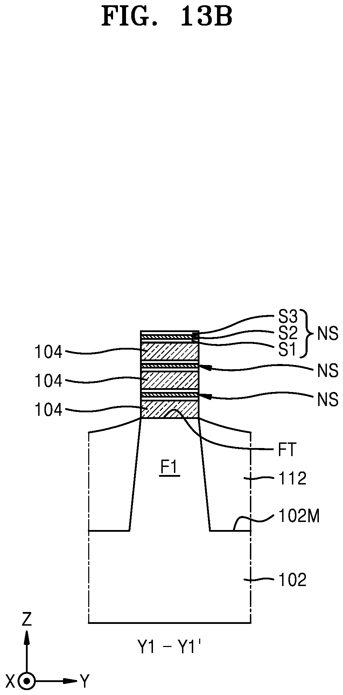

Referring to FIGS. 13A and 13B, in the resultant structure of FIGS. 12A and 12B, a recess process may be performed on the preliminary device isolation film 112P to form a device isolation film 112 having a lowered top surface. The mask pattern MP may be removed to expose a top surface of an uppermost one of the plurality of nanosheet semiconductor layers NS. A vertical level of an uppermost surface of the device isolation film 112 may be equal to or lower than a vertical level of a fin top surface FT of the fin-type active region F1.

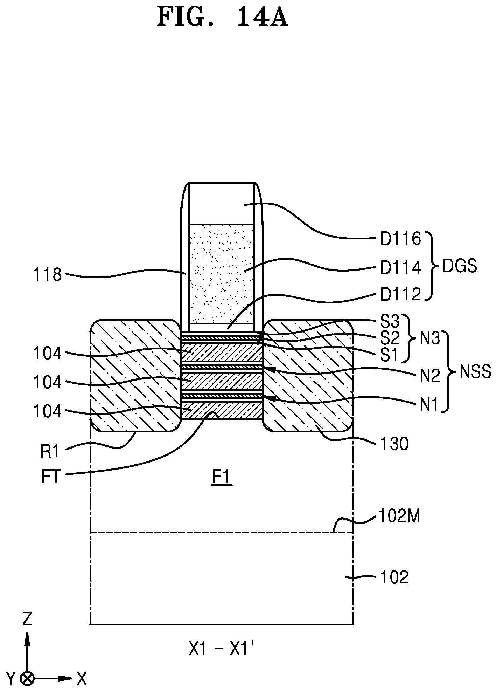

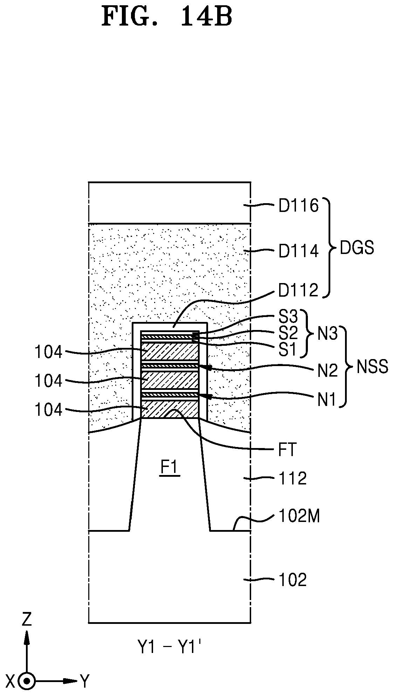

Referring to FIGS. 14A and 14B, a dummy gate structure DGS and outer insulating spacers 118 may be formed on the resultant structure of FIGS. 13A and 13B. The outer insulating spacers 118 may cover both sidewalls of the dummy gate structure DGS. The dummy gate structure DGS may be formed in a position corresponding to the gate line 160 shown in FIG. 2A and continuously extend long in a second lateral direction (Y direction).

The dummy gate structure DGS may have a structure in which an oxide film D112, a dummy gate layer D114, and a capping layer D116 are sequentially stacked. In some implementations, the dummy gate layer D114 may include a polysilicon film, and the capping layer D116 may include a silicon nitride film.

Thereafter, respective portions of the plurality of sacrificial semiconductor layers 104 and the plurality of nanosheet semiconductor layers NS may be removed by using the dummy gate structure DGS and the outer insulating spacers 118 as etch masks. Thus, a plurality of nanosheet stacks NSS may be formed from the plurality of nanosheet semiconductor layers NS. Each of the plurality of nanosheet stacks NSS may include first to third nanosheets N1, N2, and N3. A partial region of the fin-type active region F1 exposed between two adjacent ones of the plurality of nanosheet stacks NSS may be etched, and thus, a plurality of first recesses R1 may be formed in an upper portion of the fin-type active region F1. To form the plurality of first recesses R1, the fin-type active region F1 may be etched by using a dry process, a wet process, or a combination thereof.

Thereafter, a plurality of source/drain regions 130 may be formed on the fin-type active region F1 on both sides of each of the nanosheet stack NSS. To form the plurality of source/drain regions 130, a semiconductor material may be epitaxially grown from a surface of the fin-type active region F1, which is exposed at a bottom surface of each of the plurality of recesses R1, and a sidewall of each of the first to third nanosheets N1, N2, and N3. In some implementations, to form the plurality of source/drain regions 130, a low-pressure chemical vapor deposition (LPCVD) process, a selective epitaxial growth (SEG) process, or a cyclic deposition and etching (CDE) process may be performed by using source materials including a semiconductor element precursor.

In some implementations, when the plurality of source/drain regions 130 include a Si layer doped with an n-type dopant, silane (SiH₄), disilane (Si₂H₆), trisilane (Si₃H₈), and/or dichlorosilane (SiH₂Cl₂) may be used as the Si source to form the plurality of source/drain regions 130. The n-type dopant may be selected from phosphorus (P), arsenic (As), and antimony (Sb).

In other implementations, when the plurality of source/drain regions 130 include a SiGe layer doped with a p-type dopant, a silicon (Si) source and a germanium (Ge) source may be used to form the plurality of source/drain regions 130. Silane (SiH₄), disilane (Si₂H₆), trisilane (Si₃H₈), and/or dichlorosilane (SiH₂Cl₂) may be used as the Si source. Germane (GeH₄), digermane (Ge₂H₆), trigermane (Ge₃H₈), tetragermane (Ge₄H₁₀), and/or dichlorogermane (Ge₂H₂Cl₂) may be used as the Ge source. The p-type dopant may be selected from boron (B) and gallium (Ga).

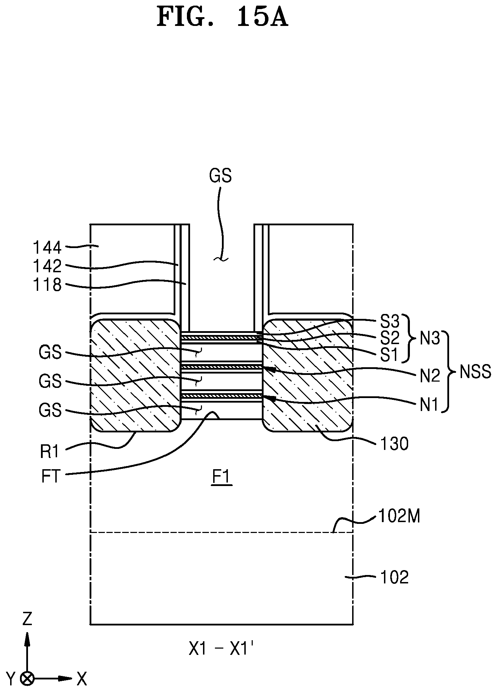

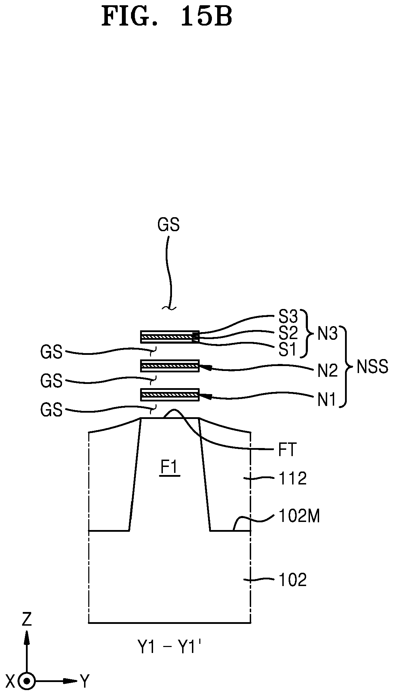

Referring to FIGS. 15A and 15B, in the resultant structure of FIGS. 14A and 14B, an insulating liner 142 may be formed to cover a surface of each of the plurality of source/drain regions 130, a surface of each of the outer insulating spacers 118, and an exposed surface of the device isolation film 112, and an inter-gate dielectric film 144 may be formed on the insulating liner 142. Thereafter, the capping layer D116 may be removed, and the outer insulating spacers 118, the insulating liner 142, and the inter-gate dielectric film 144 may be planarized to expose a top surface of the dummy gate layer D114. Afterwards, a plurality of gate spaces GS may be prepared by removing the dummy gate layer D114, which is exposed, and the oxide film D 112 disposed thereunder, and the plurality of nanosheet stacks NSS may be exposed through the plurality of gate spaces GS. Thereafter, the plurality of sacrificial semiconductor layers 104 remaining on the resultant structure may be removed through the gate spaces GS, and thus, each of the gate spaces GS may extend to respective spaces between the first to third nanosheets N1, N2, and N3 and a space between the first nanosheet N1 and the fin top surface FT of the fin-type active region F1.

In some implementations, to selectively remove the plurality of sacrificial semiconductor layers 104, differences in etch selectivity between the first to third nanosheets N1, N2, and N3 and the plurality of sacrificial semiconductor layers 104 may be used. A liquid or gaseous etchant may be used to selectively remove the plurality of sacrificial semiconductor layers 104. In some implementations, to selectively remove the plurality of sacrificial semiconductor layers 104, a CH₃COOH-based etchant, for example, an etchant including a mixture of CH₃COOH, HNO₃, and HF or an etchant including a mixture of CH₃COOH, H₂O₂, and HF may be used, without being limited thereto.

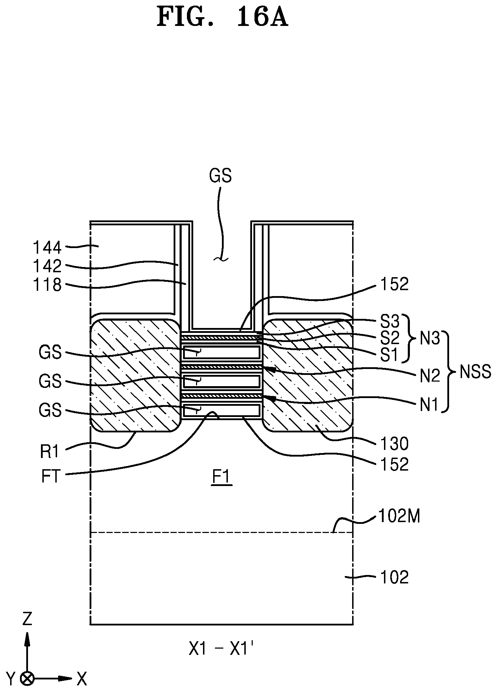

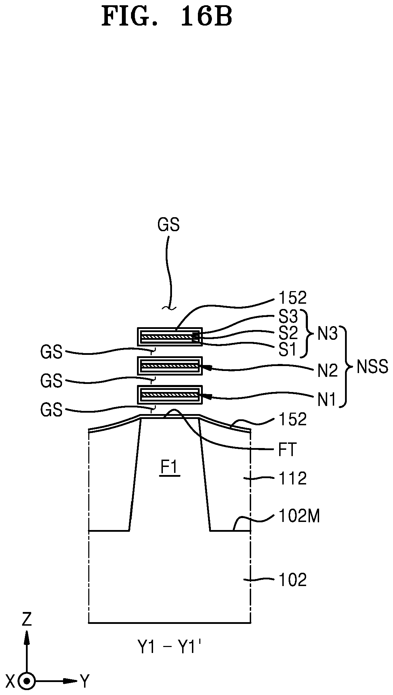

Referring to FIGS. 16A and 16B, a gate dielectric film 152 may be formed to conformally cover exposed surfaces in the resultant structure of FIGS. 15A and 15B. The gate dielectric film 152 may include a portion covering exposed surfaces of each of the first to third nanosheets N1, N2, and N3, a portion covering exposed surface of the fin-type active region F1, a portion covering exposed surfaces of the outer insulating spacers 118, and portions covering exposed surfaces of the device isolation film 112. The gate dielectric film 152 may be formed by using an atomic layer deposition (ALD) process.

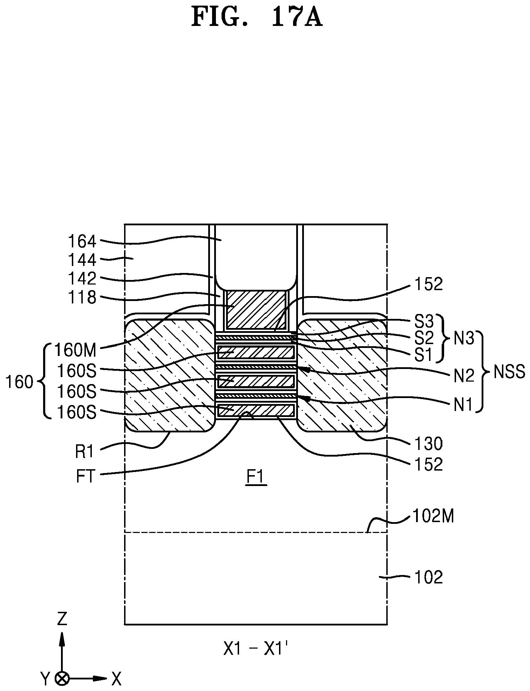

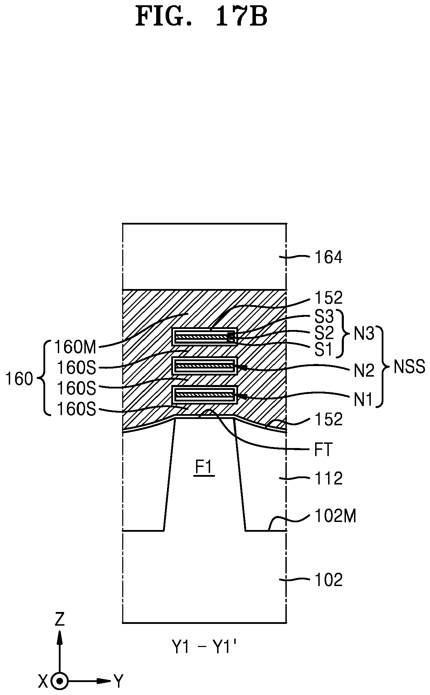

Referring to FIGS. 17A and 17B, a gate line 160 filling the plurality of gate spaces (refer to GS in FIGS. 15A and 15B) may be formed on the gate dielectric film 152. A portion of each of the gate dielectric film 152 and the gate line 160 may be removed to empty a portion of each of the plurality of gate spaces GS again. In this case, a portion of each of the outer insulating spacers 118 exposed in the gate space GS that is emptied again may be removed together. Thereafter, a capping insulating pattern 164 may be formed to cover a top surface of each of the gate dielectric film 152, the gate line 160, and the outer insulating spacers 118.

To manufacture the IC device 100A shown in FIG. 3, in the resultant structure of FIGS. 17A and 17B, respective portions of the inter-gate dielectric film 144 and the insulating liner 142 may be removed to form a plurality of contact holes 180H exposing respective partial regions of the plurality of source/drain regions 130. A metal silicide film 182 may be formed on each of the plurality of source/drain regions 130 through the plurality of contact holes 180H. A plurality of source/drain contacts 184 may be formed to fill the plurality of contact holes 180H.

Although the methods of manufacturing the IC devices 100 and 100A shown in FIGS. 1 to 3 have been described with reference to FIGS. 11A to 17B, it will be understood that the IC devices 200, 300, 400, 400A, 500, and 600 shown in FIGS. 4 to 10 or IC devices having variously changed structures may be manufactured by applying various modifications and changes to the processes described with reference to FIGS. 11A to 17B within the scope of the inventive concept.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination.

While the inventive concept has been particularly shown and described with reference to implementations thereof, it will be understood that various changes in form and details may be made therein without departing from the spirit and scope of the following claims.

## Claims

1. An integrated circuit device comprising:
a fin-type active region on a substrate;
a first nanosheet on a fin top surface of the fin-type active region, the first nanosheet being apart from the fin top surface of the fin-type active region in a vertical direction;
a gate line surrounding the first nanosheet on the fin-type active region; and
a first source/drain region on the fin-type active region, the first source/drain region being in contact with the first nanosheet,
wherein the first nanosheet comprises a multilayered sheet comprising a first outer semiconductor sheet, a core semiconductor sheet, and a second outer semiconductor sheet, wherein the first outer semiconductor sheet, the core semiconductor sheet, and the second outer semiconductor sheet are sequentially stacked in the vertical direction.

2. The integrated circuit device of claim 1, wherein each of the first outer semiconductor sheet and the second outer semiconductor sheet comprises a doped silicon, Si, layer or an undoped Si layer, and
the core semiconductor sheet comprises a doped silicon germanium, SiGe, layer or an undoped SiGe layer.

3. The integrated circuit device of claim 1, wherein the core semiconductor sheet comprises a doped SiGe layer or an undoped SiGe layer, and
a germanium, Ge, content ratio of the core semiconductor sheet is in a range of more than 0 at% and 20 at% or less.

4. The integrated circuit device of any one of claims 1 to 3, wherein a thickness of the core semiconductor sheet in the vertical direction is about 20% to about 80% of a thickness of the first nanosheet.

5. The integrated circuit device of any one of claims 1 to 4, wherein a thickness of the core semiconductor sheet is less than a thickness of each of the first outer semiconductor sheet and the second outer semiconductor sheet in the vertical direction.

6. The integrated circuit device of any one of claims 1 to 4, wherein a thickness of the core semiconductor sheet is greater than a thickness of each of the first outer semiconductor sheet and the second outer semiconductor sheet in the vertical direction.

7. The integrated circuit device of any one of claims 1 to 6, wherein the first source/drain region is in contact with each of the first outer semiconductor sheet, the core semiconductor sheet, and the second outer semiconductor sheet.

8. The integrated circuit device of any one of claims 1 to 7, wherein the first source/drain region comprises a SiGe layer doped with a p-type dopant.

9. The integrated circuit device of any one of claims 1 to 8, wherein the first source/drain region comprises a Si layer doped with an n-type dopant or a silicon carbide, SiC, layer doped with an n-type dopant.

10. The integrated circuit device of any one of claims 1 to 9, further comprising a gate dielectric film surrounding the first nanosheet on the fin-type active region, the gate dielectric film being between the first nanosheet and the gate line,
wherein the gate dielectric film is apart from the core semiconductor sheet in the vertical direction.

11. The integrated circuit device of any one of claims 1 to 10, further comprising:
a nanosheet stack apart from the fin top surface of the fin-type active region in a vertical direction, the nanosheet stack facing the fin top surface of the fin-type active region, and the nanosheet stack comprising a plurality of nanosheets including said first nanosheet, wherein the plurality of nanosheets are at different vertical distances from the fin top surface of the fin-type active region; and
a pair of source/drain regions respectively on both sides of the gate line on the fin-type active region, each source/drain region being in contact with the plurality of nanosheets, the pair of source/drain regions including said first source/drain region,
wherein each of the plurality of nanosheets comprises a multilayered sheet comprising a first outer semiconductor sheet, a core semiconductor sheet, and a second outer semiconductor sheet, which are sequentially stacked in the vertical direction,
the fin-type active region extending long in a first lateral direction on the substrate,
the gate line extending long in a second lateral direction on the fin-type active region, and
wherein the second lateral direction intersects with the first lateral direction.

12. The integrated circuit device of claim 11, wherein, in each of the plurality of nanosheets, each of the first outer semiconductor sheet and the second outer semiconductor sheet comprises a doped silicon, Si, layer or an undoped Si layer, and the core semiconductor sheet comprises a doped silicon germanium, SiGe, layer or an undoped SiGe layer.

13. The integrated circuit device of claim 11, wherein, in each of the plurality of nanosheets, the core semiconductor sheet comprises a SiGe layer, and
a germanium, Ge, content ratio of the core semiconductor sheet is in a range of more than 0 atomic percent, at%, and 20 at% or less.

14. The integrated circuit device of any one of claims 11 to 13, wherein a thickness of the core semiconductor sheet in the vertical direction is about 20% to about 80% of a thickness of the plurality of nanosheets.

15. The integrated circuit device of any one of claims 11 to 14, wherein the pair of source/drain regions comprise a silicon germanium, SiGe, layer doped with a p-type dopant.
